# FASCICULE DE BREVET EUROPEEN

(11) **EP 0 393 568 B1**
(45) Date de publication et mention de la délivrance du brevet: **06.10.1993**
(21) Numéro de dépôt: 90107231.4
(22) Date de dépôt: 17.04.1990
(51) Int. Cl.: H05K 3/30, H05K 7/12

(54) **Support de composant pour fixation dudit composant à un circuit imprimé, et procédé de réalisation et d'utilisation d'un tel support**
Bauelementunterstützung für die Befestigung dieses Bauelements an einer Leiterplatte und Verfahren zur Verwirklichung und Verwendung einer solchen Unterstützung
Component support for fastening said component to a printed circuit, and process for realizing and using such a support

(30) Priorité: 21.04.1989 FR 8905352
(43) Date de publication de la demande: 24.10.1990
(73) Titulaire: ALCATEL CIT, 75008 Paris (FR)
(72) Inventeur: Santurette, Jean-Pierre, F-45560 Saint Denis en Val (FR)
(74) Mandataire: Weinmiller, Jürgen

(56) Documents cités:
- EP-A- 0 262 549
- DE-A- 2 714 168
- US-A- 3 458 645
- US-A- 4 763 227

## Description

La présente invention concerne un support de composant pour fixation dudit composant à un circuit imprimé, voir par ex. EP-A-0262 549.

La présente invention concerne plus particulièrement un tel support pour composant du type à capsule et pattes de connexion électriques telles que, suivant le montage de cette capsule par rapport au plan du circuit imprimé, ces pattes de connexion peuvent présenter un cambrage, notamment à 90°, générateur d'instabilité de la position de ce composant au cours de la suite des opérations de montage sur ce circuit imprimé.

Ceci est le cas notamment de diodes électroluminescentes utilisées en signalisation sur la face avant de certains matériels. L'extrémité lumineuse de diodes électroluminescentes ainsi utilisées apparaît au travers d'une ouverture prévue sur ladite face avant et vient affleurer la surface extérieure de cette face, ou se présente en léger relief par rapport à cette dernière. La puissance lumineuse fournie étant faible, il importe que les diodes et les ouvertures soient en parfaite correspondance, ce qui implique un montage précis de l'une par rapport à l'autre, rendu difficile par l'instabilité mentionnée ci-dessus.

Une solution à ce problème consiste à prévoir un circuit imprimé supplémentaire parallèle à ladite face avant, sur lequel les diodes électroluminescentes peuvent être montées sans aucun cambrage de leurs pattes de connexion électrique, et relié électriquement, par un quelconque procédé de connexion, au circuit imprimé principal sur lequel sont montés les autres composants entrant dans ce matériel. Cette solution ne s'avère cependant pas optimale pour des questions d'encombrement et de coût de production de ces matériels.

Une autre solution consiste à munir ces diodes de supports destinés à conférer à celles-ci une meilleure assise sur le circuit imprimé après cambrage à 90° de leurs pattes de connexion électrique et insertion de celles-ci dans les trous correspondants du circuit imprimé.

Il existe une grande variété de tels supports qui se présentent en général sous la forme d'un bloc en matière moulée dans lequel sont insérées les diodes, et de forme étudiée pour donner la meilleure assise mécanique à l'ensemble support-diode sur le circuit imprimé.

Malgré ces supports, et malgré la légère cambrure donnée à l'extrémité des pattes de connexion électrique, il reste que l'ensemble support-diode est assez instable au cours des différentes manipulations qui précèdent l'opération de soudage à la vague des composants de ce circuit imprimé.

Pour conserver un positionnement précis, une opération supplémentaire est obligatoire et consiste par exemple, de façon manuelle, en une fixation provisoire par soudure de l'une des deux pattes de connexion électrique (avant l'opération de soudage à la vague) ou encore, en bout de chaîne, en un ajustement de la diode au niveau de l'ouverture qui lui affectée sur la face avant en jouant sur l'élasticité des connexions, ce qui n'est pas très rigoureux ; ces opérations sont par ailleurs peu pratiques et coûteuses.

La présente invention a pour but d'éviter ces inconvénients et de permettre une insertion automatique, c'est-à-dire sans aucune intervention manuelle, desdits composants sur le circuit imprimé.

La présente invention a pour objet un support de composant pour fixation dudit composant à un circuit imprimé, essentiellement caractérisé en ce qu'il est réalisé au moyen d'un matériau rendu solidaire dudit composant, et dans lequel est noyé un fil de maintien dont les extrémités dépassant dudit matériau peuvent être rabattues pour former deux pattes supplémentaires de maintien et de fixation dudit composant au circuit imprimé.

Ce support apporte donc au composant deux points de maintien supplémentaires, ce qui améliore considérablement sa stabilité au cours des différentes manipulations précédant l'opération de soudage à la vague, ces deux points étant ensuite soudés, avec le reste du circuit, au cours de cette opération de soudage à la vague.

La présente invention a également pour objet un procédé de réalisation et d'utilisation d'un tel support, convenant avantageusement à une présentation "en bande" de tels composants, prévue pour l'approvisionnement d'une machine à insertion automatique de composants.

D'autres objets et caractéristiques de la présente invention apparaîtront plus clairement à la lecture de la description suivante d'un exemple de réalisation correspondant plus particulièrement au cas où le composant est une diode électroluminescente, faite en relation avec les dessins ci-annexés dans lesquels :
- La figure 1 est une vue en perspective d'une diode électroluminescente, dans un repère Y, Y, Z.
- La figure 2 est une vue en coupe suivant un plan (X, Z) d'une diode électroluminescente fixée à un circuit imprimé avec un support suivant l'invention, suivant un montage dit "horizontal" (base de la capsule de la diode perpendiculaire au plan du circuit imprimé).
- La figure 3 est une vue en coupe partielle, suivant un plan (X, Y), d'une diode électroluminescente fixée à un circuit imprimé avec un support suivant l'invention,
- La figure 4 représente des diodes électroluminescentes conditionnées en bande et munies d'un support suivant l'invention, représentées en vue suivant un plan (Y, Z), et en coupe pour certaines d'entre elles.
- La figure 5 est une vue suivant un plan (Y, Z) d'une diode electroluminescente fixée à un circuit imprimé avec un support suivant l'invention, suivant un montage "vertical" (base de la capsule de la diode parallèle au plan du circuit imprimé).
- La figure 6 est une vue en perspective d'une diode équipée d'un support suivant l'invention, moulé directement sur la diode.
- La figure 7 est une vue en perspective d'un support suivant l'invention, destiné à équiper une diode électroluminescente.
- La figure 8 est une vue analogue à celle de la figure 2, montrant une variante de la forme du support.

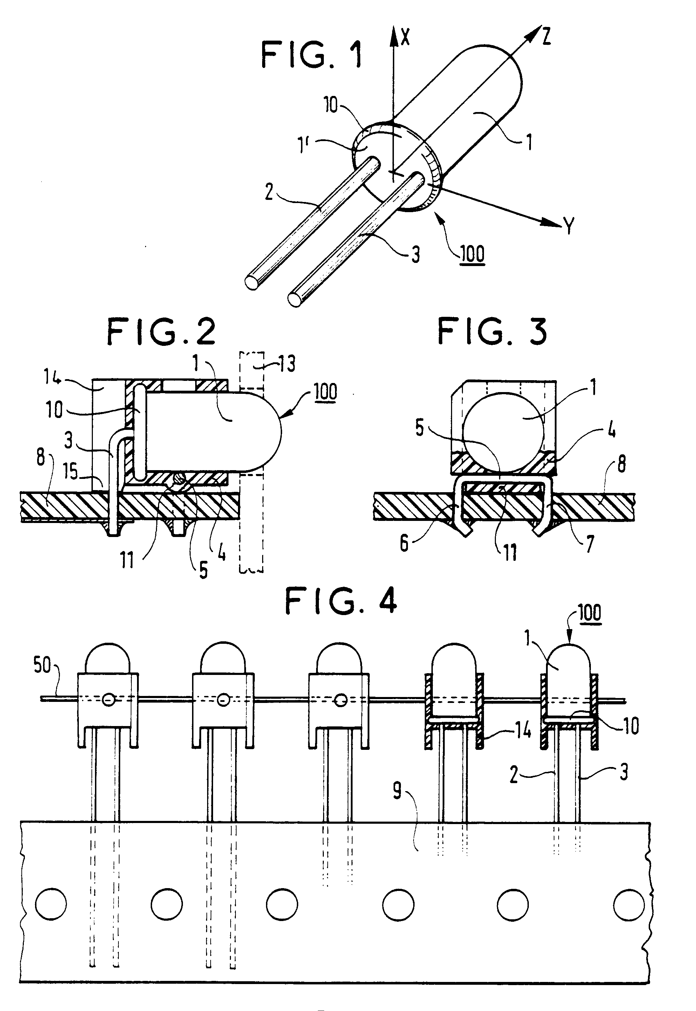

Une diode électroluminescente 100 à capsule 1 et pattes de connexion électriques 2, 3 est représentée en perspective sur la figure 1 dans un système d'axes orthogonaux X, Y, Z, le plan X, Y étant parallèle a la base 1' de la capsule par où sortent de celle-ci les pattes de connexion électriques 2, 3, et l'axe Z parallèle à ces pattes de connexion.

Une telle diode fixée à un circuit imprimé au moyen d'un support 4 est représentée sur la figure 2 en coupe suivant un plan (X, Z). Cette diode est montée sur ce circuit imprimé suivant un montage dit "horizontal" (base de la capsule de la diode perpendiculaire au plan du circuit imprimé), ses pattes de connexion 2, 3 présentant alors un cambrage à 90°. Ce support 4 est solidaire de la diode dont il laisse dégagée l'extrémité lumineuse. Il est réalisé au moyen d'un matériau, de préférence moulé, dans lequel est noyé un fil 5, dit de maintien, dont les extrémités 6 et 7 dépassant de ce matériau sont rabattues pour permettre leur insertion dans des trous d'un circuit imprimé 8 prévus à cet effet, comme représenté sur la figure 3.

Le fil de maintien est un fil rigide et cambrable qui peut être du même type que celui dans lequel sont réalisées les pattes de connexion électriques.

Sur la figure 2 est également visible en pointillés, la face avant 13 d'un matériel équipé d'une telle diode.

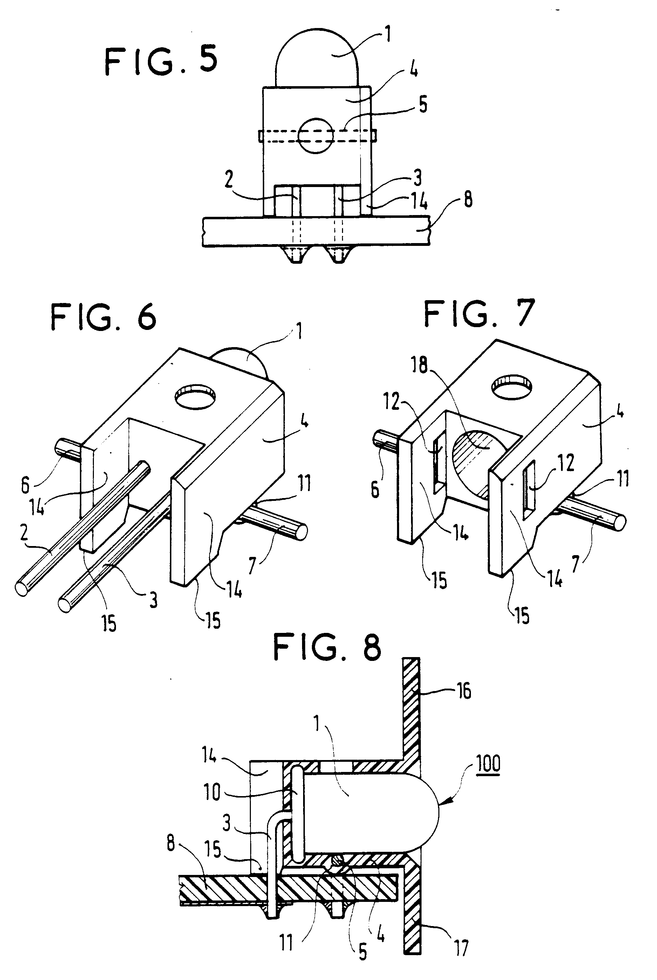

Le support 4 peut être moulé directement sur la diode, un exemple de réalisation est illustré figure 6. Avec des diodes livrées en bandes, comme représenté sur la figure 4, plusieurs diodes peuvent alors être moulées simultanément, par exemple des séries de 8-16-24 etc..., suivant la constitution du moule. Les diodes en bande sont alors mises en place dans des alvéoles correspondantes du moule, un fil continu 50 destiné à constituer les fils de maintien des futurs supports étant positionné dans les alvéoles parallèlement à la direction Y commune des différentes diodes. Les différentes phases de préparation, moulage, refroidissement étant réalisées, le moule est ouvert, et les ensembles diodes-supports sont extraits. On commande alors l'avance de la bande 9 de diodes simultanément avec le fil 50 et on recommence la même opération de moulage.

On obtient ainsi des diodes en bande équipées de leurs supports, aptes à approvisionner une machine à insertion automatique de composants, cette insertion automatique se trouvant par ailleurs facilitée par l'écartement constant maintenu entre les diodes grâce au fil continu.

Par extension on peut envisager le moulage sur des diodes non pas individuellement mais par groupes, superposées ou côte à côte, ou encore superposées et côte à côte, la mise en place et le rôle du fil étant en tous points identiques au cas envisagé précédemment.

Il peut aussi être envisagé de ne pas mouler directement les supports sur les diodes mais de fabriquer des supports moulés, en bande, non équipés de leur diode, la mise en place et le rôle du fil continu étant également en tous points identiques aux cas envisagés précédemment et les diodes étant insérées dans leurs supports dans une étape ultérieure. Chaque support est alors muni d'un moyen de retenue de la diode après la mise en place de celle-ci dans un logement constitué d'une ouverture 18 de ce support, ce moyen pouvant consister par exemple, ainsi qu'illustré à la figure 7, en une fente 12 dans laquelle vient se loger une portion de la périphérie 10 de la base 1′ de la capsule, en forme de collerette. On notera que le logement 18 traverse de part en part le support 4, qui entoure ici complétement la diode, pour permettre l'introduction de cette diode dans le support par son extrémité lumineuse et le dégagement hors du support de cette extrémité lumineuse lorsque la diode est en place dans celui-ci.

Au moment de la séparation du composant de la bande, le fil continu 50 est sectionné pour former le fil individuel de maintien 5 du support, puis ce fil 5 est rabattu de part et d'autre du moulage de manière que ses extrémités forment deux pattes supplémentaires 6, 7 insérées dans deux trous du circuit imprimé, prévus à cet effet, identiques aux trous de connexion électrique des pattes de connexion électrique 2, 3 du composant, l'extrémité de ces pattes supplémentaires 6, 7 étant ensuite légèrement cambrée (voir figure 3) afin de conférer à l'ensemble encore plus de stabilité.

Lors de l'opération de soudage à la vague des composants du circuit imprimé, la diode et son support sont alors soudés au circuit imprimé par les pattes de connexion électrique 2, 3 et par les deux pattes supplémentaires 6, 7.

Afin de faciliter l'opération ultérieure de nettoyage du circuit imprimé après soudure, pour le débarasser des résidus de flux et de résine, il est intéressant de prévoir un espacement entre le support et le circuit imprimé, sauf au niveau d'un bossage 11 du support (visible notamment sur les figures 2 et 3) par lequel ce support repose sur le circuit imprimé et se trouve donc ainsi en légère surélévation par rapport à celui-ci.

Le fil de maintien est avantageusement disposé au niveau de ce bossage, celui-ci étant situé, en projection sur l'axe Z, entre la base et l'extrémité lumineuse de la diode opposée à ladite base, à une distance suffisante de cette base pour que les deux points de maintien supplémentaires de la diode que procure le fil de maintien 5 améliorent très sensiblement la tenue de celle-ci sur le circuit imprimé.

Un composant muni d'un tel support pourrait également, quoique l'intérêt en soit très réduit, être monté non plus horizontalement comme sur les figures précédentes, mais verticalement, comme représenté sur la figure 5 (c'est-à-dire avec la base de sa capsule parallèle au circuit imprimé). Le fil 5 serait alors coupé au ras du support de part et d'autre.

La forme extérieure du support, de même que ses dimensions, c'est-à-dire la mesure dans laquelle il enrobe le composant sur une plus ou moins grande partie de sa capsule et/ou de ses pattes de connexion électrique, le matériau de moulage devant dans ce dernier cas être isolant, importent peu pour la résolution du problème technique considéré pour laquelle il suffit de disposer d'un volume de matériau de moulage apte à renfermer le composant dans une mesure suffisante pour rendre ce composant solidaire dudit support et donc des deux pattes supplémentaires de maintien et de fixation au circuit imprimé. Par ailleurs le support dans lequel est noyé le fil de maintien pourrait être rendu solidaire du composant par des moyens autres que le moulage.

Cette forme extérieure et ces dimensions du support varient suivant les composants et leurs applications.

Elles peuvent néanmoins contribuer à conférer à l'ensemble composant-support encore plus de stabilité. Il en est ainsi dans l'exemple décrit ci-dessus des prolongements 14, visibles sur les figures 2, 6, 7 et 8, donnés aux faces du bloc de matériau de moulage perpendiculaires au circuit imprimé, au niveau des pattes de connexion du composant. Ces deux faces présentent par ailleurs chacune, au niveau de leur prolongement, un décrochement 15 servant d'appui arrière à l'ensemble composant-support et le surélevant d'une hauteur identique à celle du bossage 11.

Comme montré sur la figure 8 (prise dans un même plan que la figure 2) le bloc de matériau de moulage peut également présenter des prolongements 16, 17 suivant un plan parallèle à la base de la capsule, de part et d'autre de son ouverture destinée à recevoir l'extrémité lumineuse de la diode. Ces prolongements réalisent en eux-mêmes une face avant directement intégrée au support, permettant un éventuel repérage par étiquette ou marquage par exemple.

## Revendications

1. Support de composant pour fixation dudit composant (100) à un circuit imprimé (8), caractérisé en ce qu'il est réalisé au moyen d'un matériau rendu solidaire dudit composant, et dans lequel est noyé un fil de maintien (5) dont les extrémités (6, 7) dépassant dudit matériau peuvent être rabattues pour former deux pattes supplémentaires de maintien et de fixation dudit composant au circuit imprimé.

2. Support de composant selon la revendication 1, caractérisé en ce qu'il comporte à sa périphérie un bossage (11) par lequel il repose sur le circuit imprimé (8) lorsque le composant supporté (100) est monté avec un cambrage à 90° de ses pattes de connexion électrique (2, 3).

3. Support selon la revendication 2, caractérisé en ce que le fil de maintien (5) est placé dans ledit matériau au niveau de ce bossage (11).

4. Support selon l'une des revendications 1 à 3, caractérisé en ce qu'il est muni d'un moyen (12) de retenue du composant.

5. Support selon l'une des revendications 1 à 3, caractérisé en ce que ledit matériau est rendu solidaire dudit composant par moulage.

6. Procédé de réalisation d'un support de composant selon l'une des revendications 1 à 3, pour composants conditionnés en bande (9), caractérisé en ce qu'il consiste à mouler en une seule étape des supports pour un groupe de composants successifs portés par cette bande, en utilisant un même fil continu (50) pour la constitution des fils de maintien individuels (5) de ces supports.

7. Procédé selon la revendication 6, caractérisé en ce que, les supports étant moulés directement sur les composants, cette opération de moulage est répétée par groupes de composants successifs portés par cette bande, en commandant à chaque fois de façon concomitante l'avancement de la bande (9) et l'avancement du fil continu (50).

8. Procédé selon la revendication 6, caractérisé en ce que les composants sont introduits dans leurs supports dans une étape ultérieure au moulage de ces supports.

9. Procédé d'utilisation d'un support réalisé suivant l'une des revendications 6 à 8, caractérisé en ce qu'il consiste à sectionner ledit fil continu (50) et à séparer le composant de la bande, à rabattre les extrémités de la portion de fil continu ainsi obtenue, constituant le fil de maintien (5) du support, de part et d'autre du moulage pour former deux pattes supplémentaires de maintien et de fixation, et à insérer ces deux pattes supplémentaires dans deux trous du circuit imprimé prévus à cet effet.

10. Procédé selon la revendication 9, caractérisé en ce que les extrémités de ces pattes supplémentaires sont cambrées après insertion dans les trous correspondants du circuit imprimé.

11. Procédé selon l'une des revendications 9 et 10, caractérisé en ce que ces pattes supplémentaires sont ensuite soudées en même temps que les pattes de connexion électrique du composant.

## Patentansprüche

1. Bauelementeträger zur Befestigung des Bauelements (100) auf einer Druckschaltung (8), dadurch gekennzeichnet, daß er aus einem Material hergestellt ist, das mit dem Bauelement fest verbunden wird und in das ein Haltedraht (5) eingebettet ist, dessen Enden (6, 7), die aus dem Material vorstehen, umgebogen werden können, um zwei zusätzliche Halte- und Befestigungsfüße des Bauelements auf der Druckschaltung zu bilden.

2. Bauelementeträger nach Anspruch 1, dadurch gekennzeichnet, daß er an seinem Umfang einen Wulst (11) aufweist, über den er auf der Druckschaltung (8) aufliegt, wenn das in ihm enthaltene Bauelement (100) unter Umbiegen seiner elektrischen Anschlußfüße (2, 3) um 90° montiert ist.

3. Träger nach Anspruch 2, dadurch gekennzeichnet, daß der Haltedraht (5) in dem Material in Höhe dieses Wulstes (11) angeordnet ist.

4. Träger nach einem der Ansprüche 1 bis 3, dadurch gekennzeichnet, daß er ein Mittel (12) zum Festhalten des Bauelements besitzt.

5. Träger nach einem der Ansprüche 1 bis 3, dadurch gekennzeichnet, daß das Material mit dem Bauelement durch Übergießen fest verbunden ist.

6. Verfahren zur Herstellung eines Bauelementeträgers nach einem der Ansprüche 1 bis 3 für in Streifenform (9) angelieferte Bauelemente, dadurch gekennzeichnet, daß in einem einzigen Verfahrensschritt Träger für eine Gruppe von auf diesem Band aufeinanderfolgend befestigten Bauelementen gegossen werden, indem ein durchgehender Draht (50) zur Bildung der einzelnen Haltedrähte (5) dieser Träger verwendet wird.

7. Verfahren nach Anspruch 6, dadurch gekennzeichnet, daß im Falle des direkten Aufgießens der Träger auf die Bauelemente diese Gießoperation für aufeinanderfolgende Gruppen von auf diesem Streifen liegenden Bauelementen wiederholt wird, indem jedesmal in gleicher Weise der Vorschub des Streifens (9) und der des durchgehenden Drahts (50) gesteuert wird.

8. Verfahren nach Anspruch 6, dadurch gekennzeichnet, daß die Bauelemente in ihre Träger in einem auf das Gießen dieser Träger folgenden Verfahrensschritt eingesteckt werden.

9. Verfahren zur Verwendung eines nach einem der Ansprüche 6 bis 8 hergestellten Trägers, dadurch gekennzeichnet, daß es darin besteht, den durchgehenden Draht (50) zu zerschneiden und das Bauelement von dem Streifen abzutrennen, die Enden der so erhaltenen Drahtstücke, die den Haltedraht (5) des Trägers bilden, zu beiden Seiten des Gußteils umzubiegen, um zwei zusätzliche Halte- und Befestigungsfüße zu bilden, und diese beiden zusätzlichen Füße in zwei zu diesem Zweck in der Druckschaltung vorgesehene Löcher einzustecken.

10. Verfahren nach Anspruch 9, dadurch gekennzeichnet, daß die Enden dieser zusätzlichen Füße nach dem Einfügen in die entsprechenden Löcher der Druckschaltung umgebogen werden.

11. Verfahren nach einem der Ansprüche 9 und 10, dadurch gekennzeichnet, daß diese zusätzlichen Füße dann gleichzeitig mit den elektrischen Anschlußfüßen des Bauelements angelötet werden.

## Claims

1. Component support for fixing said component (100) to a printed circuit (8) characterised in that it is made from a material fastened to said component and in which is embedded a holding wire (5) whose ends (6, 7) projecting from said material are adapted to be bent to form two additional holding leads for fixing said component to the printed circuit.

2. Component support according to claim 1 characterised in that it comprises at its periphery a boss (11) through which it bears on the printed circuit (8) when the supported component (100) is mounted with its electrical connecting leads (2, 3) bent at 90°.

3. Support according to claim 2 characterised in that the holding wire (5) is disposed in said material at the level of said boss (11).

4. Support according to any one of claims 1 to 3 characterised in that it comprises component retaining means (12).

5. Support according to any one of claims 1 to 3 characterised in that said material is overmoulded onto said component.

6. Method of manufacturing a component support according to any one of claims 1 to 3 for stripform packaged components (9) characterised in that it consists in moulding in a single stage supports for a group of successive components carried by said strip using a common continuous wire (50) to constitute the individual holding wires (5) of said supports.

7. Method according to claim 6 characterised in that the supports are overmoulded directly onto the components and said overmoulding operation is repeated for successive groups of components carried by said strip, advance of the strip (9) and advance of the continuous wire (50) being commanded concomitantly each time.

8. Method according to claim 6 characterised in that the components are inserted in their support in a stage subsequent to the moulding of said supports.

9. Method of using a support manufactured according to any one of claims 6 to 8 characterised in that it consists in cutting said continuous wire (50) and separating the component from the strip, bending the ends of the portion of continuous wire thus obtained and constituting the support holding wire (5) on each side of the moulding to form two additional holding and fixing leads and inserting said two additional leads into two holes of the printed circuit provided for this purpose.

10. Method according to claim 9 characterised in that the ends of the additional leads are bent after they are inserted in the respective holes of the printed circuit.

11. Method according to claim 9 or claim 10 characterised in that said additional leads are then soldered at the same time as the electrical connecting leads of the component.
